(19) Europäisches Patentamt
European Patent Office
Office européen des brevets

(11)  **EP 3 404 831 B1**

(12)  **EUROPEAN PATENT SPECIFICATION**

(45)  Date of publication and mention
of the grant of the patent:
**21.04.2021  Bulletin 2021/16**

(51)  Int Cl.:
***H03F 3/08*** *(2006.01)*

(21)  Application number: **17305555.9**

(22)  Date of filing: **16.05.2017**

(54)  **PHOTORECEIVER WITH PRE-EQUALIZING DIFFERENTIAL TRANSIMPEDANCE AMPLIFIER**

LICHTEMPFÄNGER MIT VORENTZERRENDEM DIFFERENTIELLEM TRANSIMPEDANZVERSTÄRKER

PHOTORÉCEPTEUR AVEC AMPLIFICATEUR DE TRANSIMPÉDANCE DIFFÉRENTIELLE DE PRÉ-ÉGALISATION

(84)  Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43)  Date of publication of application:
**21.11.2018  Bulletin 2018/47**

(73)  Proprietor: **Nokia Solutions and Networks Oy 02610 Espoo (FI)**

(72)  Inventors:
• **ANGELINI, Philippe**
**91767 Palaiseau (FR)**
• **BLACHE, Fabrice**
**91767 Palaiseau (FR)**
• **DUPUY, Jean-Yves**
**91767 Palaiseau (FR)**

(74)  Representative: **Loyer & Abello**
**9, rue Anatole de la Forge**
**75017 Paris (FR)**

(56)  References cited:
JP-A- S6 259 822      US-A- 3 491 307
US-A- 5 307 024      US-A- 5 612 810
US-A- 5 886 578      US-A1- 2001 004 388
US-A1- 2004 129 862   US-A1- 2004 130 397
US-A1- 2015 372 652   US-A1- 2016 028 560
US-B1- 6 768 384      US-B1- 9 276 529
US-B2- 8 456 240

**Description**

**Field of the invention**

The invention relates to the technical field of photoreceivers.

**Background**

In fiber optic telecommunication, the front-end architecture of the optical receiver plays a critical role in the optical receiver performances. After the light has travelled over great distances, it is collected on a photodetector 1000 that generates an electrical signal in response to the optical excitation.

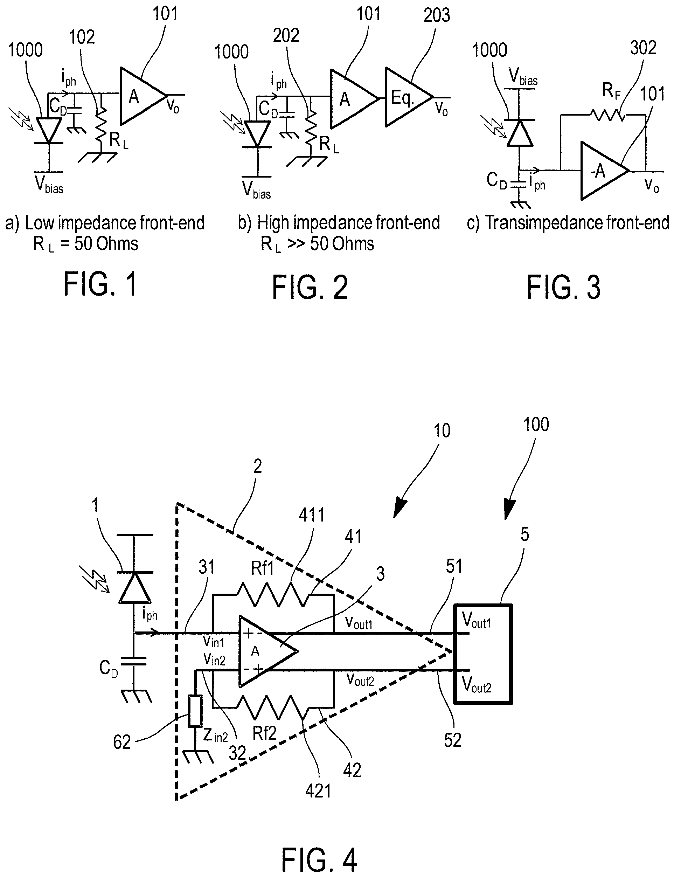

The prior art provides for three front-end architecture types. Each has pros and cons. The low impedance front-end, illustrated by Figure 1, is the simplest architecture, which consists of a load resistor 102 used to convert the photocurrent into a voltage. The voltage is then amplified by a high input impedance (ideally infinite) voltage amplifier 101, which can be a commercial microwave amplifier. This kind of architecture shows a good dynamic range and wide bandwidth $BW = \dfrac{1}{2\pi R_L C_T}$, $C_T$ being the total equivalent capacitance of the photodiode $C_D$ added to any other shunt parasitic (typically the input capacitance of the voltage amplifier), $R_L$ the impedance of the load resistor 102. Nevertheless, for systems requiring high sensitivity, this topology shows its limitation due to the high thermal current noise spectral density $i_{th}^2 = \dfrac{4\mathrm{kT}}{\mathrm{R_L}}$ degrading the signal-to-noise ratio.

The high impedance front-end, illustrated by Figure 2, minimizes the receiver thermal noise by using a very large resistor 202, which makes it one of the highest sensitivity front-end. The problem encountered is that the high impedance topology leads to a lower bandwidth $BW = \dfrac{1}{2\pi R_L C_T}$. As a result, the input voltage of the amplifier (across resistor 202) is a low-pass-filtered image of the photocurrent, suffering from inter-symbol interferences. Thus, one must equalize the response with an equalizer 203 to obtain a flat frequency response in the frequency range of interest. The large low-frequency conversion gain of this photoreceiver, equal to $R_L A$, can overload the equalizer 203 for large optical input power values, thus limiting the dynamic range of the high-impedance front-end.

The transimpedance front-end, illustrated by Figure 3, provides a good compromise between the low noise characteristics of the high-impedance front-end and the large bandwidth of the low-impedance front-end. This is due to the fact that the equivalent input resistance is equal to $R_{Leq} = R_F/(A + 1)$ (where the feedback resistor 302, named $R_F$, is used instead of $R_L$) thus, if $R_F = R_L$ the bandwidth $BW = \dfrac{1}{2\pi R_{Leq} C_T} = \dfrac{A+1}{2\pi R_F C_T}$ is multiplied by ($A + 1$), while the thermal current noise spectral density is equal to $i_{th}^2 = \dfrac{4\mathrm{kT}}{\mathrm{R_F}}$ is unchanged. Thus one can have ($A + 1$) times less noise for the same bandwidth or ($A + 1$) times more bandwidth for the same noise. To achieve ever higher data rate, beyond what a given transimpedance amplifier in a given technology can achieve, an equalizer can be placed after the transimpedance amplifier. However, this improvement adds power and space consumption.

US 6,768,384 discloses another transimpedance frontend using a fully differential amplifier comprising a first input connected to a photo diode and a second input connected to a current source. The current source is used for absorbing the current from the feedback loop coupled to the second input in such a way to increase the gain.

**Summary**

The basic idea of the invention is to pre-compensate the frequency response of the photoreceiver thanks to the properties of a fully differential transimpedance amplifier.

The invention provides for an improved high speed optical communication receiver with increased bandwidth and signal-to-noise performances.

The invention is defined by the subject matter of independent claim 1 and provides a front-end architecture for a photoreceiver, the front-end architecture including a photodiode and a fully differential amplifier, the fully differential amplifier comprising a differential input amplifier having a primary input, and $N$ secondary inputs, wherein $N \geq 1$, a primary output, a secondary output, a primary negative feedback path from the primary output to the primary input, and, for each one of the $N$ secondary inputs, a secondary negative feedback path from the secondary output to said secondary input, the primary negative feedback path including a primary feedback element, each secondary negative feedback path including a secondary feedback element, wherein an anode of the photodiode is connected to the primary input of the differential input amplifier, and that each of the secondary inputs is loaded by a respective impedance by connecting the secondary input to a transmission line loaded by an open circuit.

In embodiments, the primary input is a non-inverting input with respect to the primary output, the at least one secondary input is an inverting input with respect to the secondary output, wherein the primary output is an inverting output with respect to the primary input, and wherein the secondary output is a non-inverting output with respect to the at least one secondary input.

In embodiments, the primary input is an inverting input with respect to the primary output, the at least one secondary input, is a non-inverting input with respect to the secondary output, wherein the primary output is a non-inverting output with respect to the primary input, and wherein the secondary output is an inverting output with respect to the at least one secondary input.

The invention allows increasing the speed of the optical communication that can be received, while reducing the complexity, cost, and power consumption of the photoreceiver by integrating transimpedance amplification and equalization on one single chip. The invention is particularly useful for emerging multi-level optical modulation formats for very high speed optical systems, where equalization is increasingly required.

The invention makes it possible to at least halve the power consumption compared to a photoreceiver of the prior art having a separate cascaded transimpedance amplifier and equalizer implementation. The invention allows longer transmission reach for short reach applications like intra data center networks. The invention also allows reducing the need for digital signal processing thereby reducing the overall power consumption of the system.

In embodiments, such a front-end architecture may include one or more of the features below.

In an embodiment, the primary feedback element and the secondary feedback element(s) are resistors.

In an embodiment, the primary feedback element and the secondary feedback element(s) have a same impedance.

In a preferred embodiment, $N \geq 2$.

In an embodiment, the differential input amplifier includes a differential stage, a buffer stage, and a level-shifting stage. In an embodiment, the differential stage includes a primary differential stage transistor and, for each inverting input, a secondary differential stage transistor, the buffer stage including a primary buffer stage transistor and, for each inverting input, a secondary buffer stage transistor, and the level-shifting stage including a primary level-shifting stage transistor and, for each inverting input, a secondary level-shifting stage transistor, each one of the transistors including a base, a collector, and an emitter.

In an embodiment, the base of the primary differential stage transistor is connected to the non-inverting input, the collector of the primary differential stage transistor is connected to the base of the primary buffer stage transistor, the emitter of the primary buffer stage transistor is connected to the collector of the primary level-shifting stage transistor, the base of the primary differential stage transistor is connected to the collector of the primary level-shifting stage transistor through the primary feedback element, the emitter of the primary level-shifting stage transistor is connected to the inverting output, and, for each of the inverting inputs, the base of the associated secondary differential stage transistors is connected to the inverting input, the collector of the associated secondary differential stage transistors is connected to the base of the associated secondary buffer stage transistor, the emitter of the associated secondary buffer stage transistor is connected to the collector of the associated secondary level-shifting stage transistor, the base of the associated secondary differential stage transistor is connected to the collector of the associated secondary level-shifting stage transistor through the associated secondary feedback element, the emitter of the associated secondary level-shifting stage transistor is connected to the non-inverting output.

In an embodiment, the invention also provides a photoreceiver including the above described a front-end architecture.

In an embodiment, the inverting output and non-inverting output are connected to a two stages differential feedback amplifier gain stage.

In an embodiment, the two stages differential feedback amplifier gain stage is a Cherry-Hooper gain stage.

## Brief description of the drawings

These and other aspects of the invention will be apparent from and elucidated with reference to the embodiments described hereinafter, by way of example, with reference to the drawings.

Figure 1 illustrates a low impedance front-end architecture of a photoreceiver according to the prior art.

Figure 2 illustrates a high impedance front-end architecture of a photoreceiver according to the prior art.

Figure 3 illustrates a transimpedance front-end architecture of a photoreceiver according to the prior art.

Figure 4 illustrates a front-end architecture of a photoreceiver according to an embodiment which is not part of the invention but is useful for its comprehension.

Figure 5a is a functional representation of the front-end architecture of figure 4.

Figure 5b is a block diagram representation of the front-end architecture of figure 4.

Figure 6 is an example of a bipolar junction transistor (BJT) implementation of a fully differential transimpedance amplifier according to an aspect of the invention.

Figure 7a is an eye diagram of the transimpedance front-end architecture of figure 3.

Figure 7b is an eye diagram of a front-end architecture according to an embodiment of the invention.

Figure 8a is a functional representation of a front-end architecture of a photoreceiver according to another embodiment of the invention.

Figure 8b is a block diagram representation of the front-end architecture of figure 8a.

Figure 8c is an example of a front-end architecture according to the embodiment of figure 8b.

Figure 9a shows the simulated photodiode optical-to-electrical response, the simulated TIA gain, and the simulated photodiode and TIA optical-to-electrical response of a photoreceiver using a high speed photodiode model integrated with the front-end architecture of figure 3.

Figure 9b shows the simulated photodiode optical-to-electrical response, the simulated TIA gain, and the simulated photodiode and TIA optical-to-electrical response of a photoreceiver according to an embodiment of the invention.

## Detailed description of the embodiments

Figure 4 illustrates a front-end architecture 10 of a photoreceiver 100 using a photodiode 1 and including a fully differential transimpedance amplifier 2.

The fully differential transimpedance amplifier 2 comprises a differential input amplifier 3 having a primary input 31 at a voltage $V_{in1}$, a secondary input 32 at a voltage $V_{in2}$, a primary output 51 at a voltage $V_{out1}$, a secondary output 52 at a voltage $V_{out2}$. The differential input amplifier 3 has a voltage gain $A$.

The photodiode 1 is connected to the primary input 31 of the fully differential transimpedance amplifier 2.

Hereinafter, the primary input 31 is a non-inverting input, the secondary input 32 is an inverting input, the primary output 51 is an inverting output, and the secondary output 52 is a non-inverting output. However, it should be noted that, alternatively, the primary input 31 may be an inverting input, the secondary input 32 being non-inverting inputs, the primary output 51 being a non-inverting output, and the secondary output 52 being an inverting output.

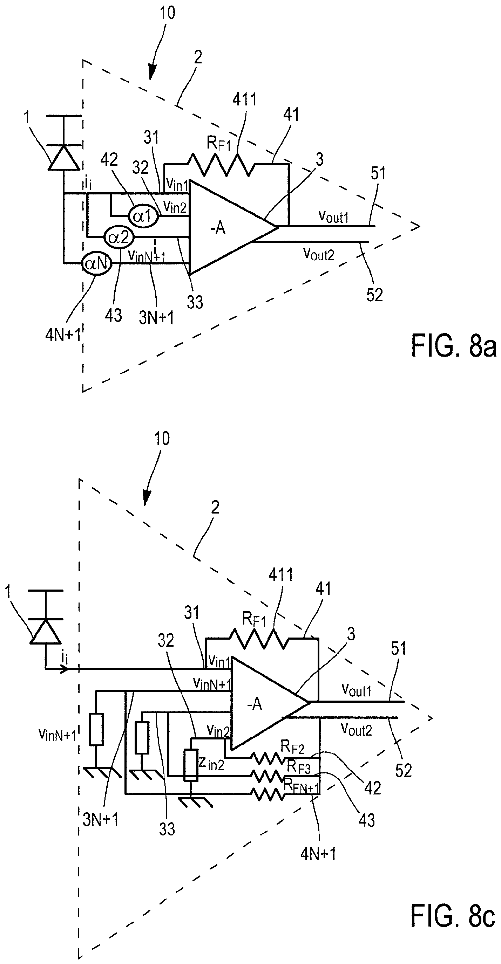

As will be described in relation to figure 8a, the fully differential transimpedance amplifier 2 may include $N$ inverting inputs, wherein $N$ is a positive integer equal or superior to 1. In the example illustrated by figure 4, $N$ is equal to 1.

The fully differential transimpedance amplifier 2 comprises a differential input amplifier 3 having a non-inverting input 31 at a voltage $V_{in}$ , $N$ inverting inputs 32,...3N+1 respectively at a voltage $V_{in2},...V_{inN+1}$, an inverting output 51 at a voltage $V_{out1}$, a non-inverting output 52 at a voltage $V_{out2}$. The differential input amplifier 3 has an voltage gain $A$. The differential input amplifier 3 may be modeled by a differential current controlled voltage source (CCVS), and may be realized with a differential pair amplifier, or any other differential pair implementation known in the art, like a cascade amplifier, a common base amplifier, etc., with or without any buffer amplifier.

The anode of the photodiode 1 is connected to the non-inverting input $V_{in1}$ of differential input amplifier 3. The cathode of the photodiode 1 is connected to a voltage reference (ground or external power supply to bias the photodiode).

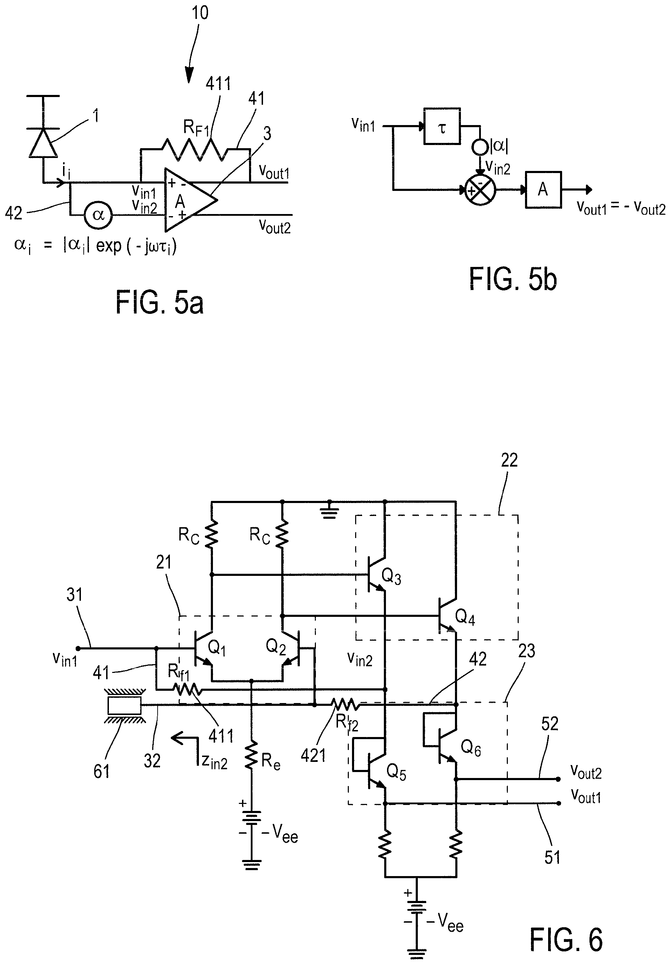

The inverting input 32 is loaded by an impedance $Z_{in2}$. In particular, the inverting input 32 is connected to a transmission line loaded by an open circuit having an impedance $Z_{in2}$ as will be described in relation to figure 6. This provides a low-impedance load for the photodiode 1, which keeps the photodiode voltage low.

A primary feedback branch 41 creates a feedback from the inverting output 51 to the non-inverting input 31. A secondary feedback branch 42 creates a feedback from the non-inverting output 52 to the inverting input 32.

The primary feedback 41 includes a primary feedback element 411 that may in particular be a resistor, but may also be any other kind of impedance like a resistor in parallel with a capacitor or a MOS transistor. The secondary feedback 42 includes a secondary feedback element 421 that may be a resistor. The primary 411 and secondary 421 feedback elements have respective impedances $R_{f1}$ and $R_{f2}$, that is preferably comprised between 100 Ω and 300 Ω.

The conversion gain $H(\omega)$ of the photoreceiver is:

$$H(\omega) = \frac{v_{out1}}{i_{ph}} = -\frac{v_{out2}}{i_{ph}} = \frac{-AR_{F1}}{(1+jC_TR_{F1}\omega)(1+\frac{AZ_{IN2}}{Z_{IN2}+R_{F2}})+A}$$

The output voltages are defined as : $V_{out1} = -V_{out2} = A(V_{in1}-V_{in2}) = A(V_{in1}-\alpha V_{in1})$.

The primary feedback 41 is a negative feedback. It lowers the input impedance of the differential input amplifier 3 and raises its cut-off frequency, as a result of which the overall bandwidth of the photoreceiver increases.

The photodiode 1 is operating in the photoconductive mode, since a reverse bias is applied either by a positive voltage at the cathode or by the voltage at the inputs 31, 32 of the differential input amplifier 51. This reverse bias increases the width of the depletion region and lowers the junction capacitance, improving the high-frequency performance of the receiver. The input offset voltage caused by the photodiode may be compensated by adding a low current polar tee at one of the inputs 31, 32, or by applying a compensating offset at one of the inputs 31, 32. In an automatic implementation, a filter network and low frequency amplifiers connecting both inputs 31, 32 may be used to compensate the offset.

The secondary feedback 42 is also a negative feedback. The voltage $V_{in2}$ at the inverting input 32 is an attenuated and delayed image of the voltage at the non-inverting input $V_{in1}$, the useful signal from the photodiode. The secondary feedback 42 allows the equalization of the signal from the photodiode. As illustrated by figure 5a, the front-end architecture 10 acts as a transversal filter (such as a Feed-Forward Equalizer, which is illustrated in Figure 5b) without any external device, directly by integrating passive elements, such as the CPW transmission line loaded by an open circuit 61 (illustrated by figure 6) or lumped elements, or active elements such as the varactor 62 (illustrated by figure 4). Figure 6 shows a bipolar junction transistor (BJT) implementation of a fully differential transimpedance amplifier 2. The differential input amplifier 3 includes a differential stage 21 including a primary differential stage transistor Q1 and a secondary differential stage transistor Q2, a buffer stage 22 including a primary buffer stage transistor Q3 and a secondary buffer stage transistor Q4, and a level-shifting stage 23 including a primary level-shifting stage transistor Q5 and a secondary level-shifting stage transistor Q6. Each one of the transistors Q1-Q6 includes a base, a collector, and an emitter.

The base of the primary differential stage transistor Q1 is connected to the non-inverting input 31. The base of the secondary differential stage transistor Q2 is connected to the inverting input 32. The inverting input 32 may in particular be connected to a coplanar waveguide (CPW) transmission line 61, which is open-circuited. The CPW transmission line 61 is designed to maximize the 3-dB bandwidth while having the flattest frequency response. The impedance $Z_{in2}$ is formed between the CPW transmission line 61 and the ground.

The collector of the primary differential stage transistor Q1 is connected to the base of the primary buffer stage transistor Q3. The emitter of primary buffer stage transistor Q3 is connected to the collector of the primary level-shifting stage transistor Q5. The base of the primary differential stage transistor Q1 is connected to the collector of the primary level-shifting stage transistor Q5 through the primary feedback element 411. The emitter of the primary level-shifting stage transistor Q5 is connected to the inverting output 51.

The emitter of the secondary buffer stage transistor Q4 is connected to the collector of the secondary level-shifting stage transistor Q6. The collector of the secondary differential stage transistor Q2 is connected to the base of the secondary buffer stage transistor Q4. The base of the secondary differential stage transistor Q2 is connected to the collector of the secondary level-shifting stage transistor Q6 through the secondary feedback element 421. The emitter of the secondary level-shifting stage transistor Q6 is connected to the non-inverting output 52.

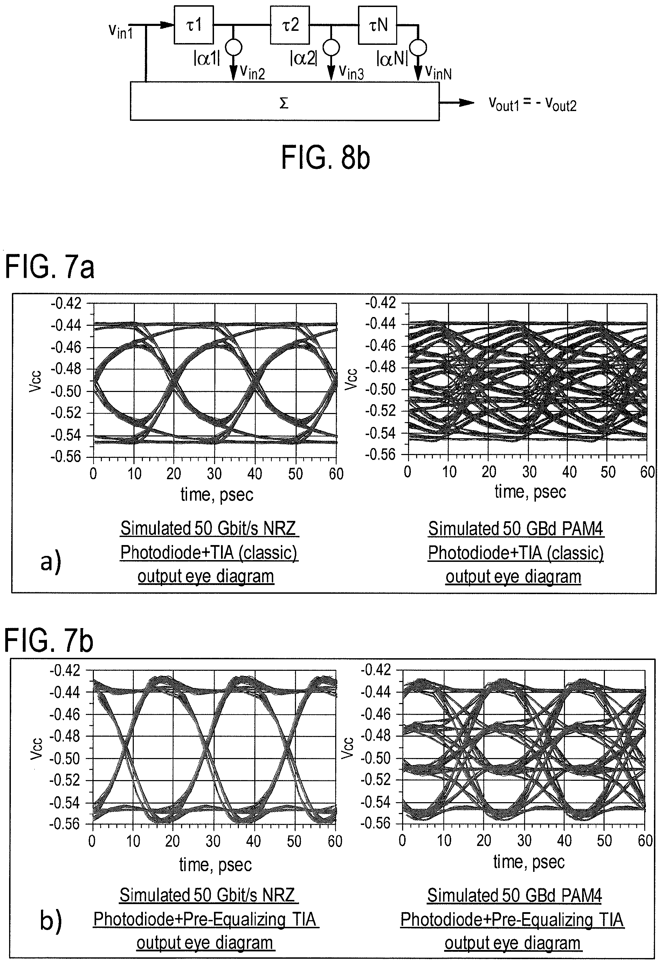

A front-end architecture 10 having $N$ secondary feedback paths 42, 43, 4N+1 will now be described in relation to figures 8a and 8b. The differential input amplifier 3 includes $N$ inverting inputs. Each one of the $N$ secondary feedback paths 42, 43, 4N+1 is similar to the secondary feedback path 42 described in relation to figure 4 and creates a feedback from the non-inverting output $V_{out2}$ to one of inverting inputs $V_{in2}, ... V_{inN+1}$ of the differential input amplifier 3. In particular, as illustrated by figure 8c, each one of the $N$ secondary feedback paths 42, 43, 4N+1 includes a respective secondary feedback element similar to the secondary feedback element 421 and having respective impedances $R_{f2}, R_{f3},... R_{fN+1}$.

In particular, the differential stage 21 may include for each inverting input 32, 33, ... 3N + 1, a secondary differential stage transistor (identical to Q2 of figure 6 but not shown on figure 8a), the buffer stage 22 including, for each inverting input 32, 33, ... 3N + 1, a secondary buffer stage transistor (identical to Q4 of figure 6 but not shown on figure 8a), and the level-shifting stage 23 including, for each inverting input 32, 33, ... 3N + 1, a secondary level-shifting stage transistor (identical to Q6 of figure 6 but not shown on figure 8a). For each of the inverting inputs 32, 33, ... 3N + 1, the base of the associated secondary differential stage transistors is connected to the inverting input 32, 33,... 3N + 1, the collector of the associated secondary differential stage transistors is connected to the base of the associated secondary buffer stage transistor, the emitter of the associated secondary buffer stage transistor is connected to the collector of the associated secondary level-shifting stage transistor, the base of the associated secondary differential stage transistor is connected to the collector of the associated secondary level-shifting stage transistor through the associated secondary feedback element, the emitter of the associated secondary level-shifting stage transistor Q6 is connected to the non-inverting output 52.

As illustrated by figure 8a, the output voltages $V_{out1}$ and $V_{out2}$ are defined as :

$$V_{out1} = -V_{out2} = A \sum_{0}^{N} |\alpha_i| V_{in1} (t - \tau_i)$$

Each input voltage $V_{in2}$, ... $V_{inN+1}$ at an inverting input 32, 33...3N+1 is an attenuated and delayed image of the useful signal $V_{in1}$ from the photodiode, wherein the attenuation of the signal decreases with the increase of the delay. Each additional secondary feedback 42, 43, 4N+1 further improves the equalization of the signal from the photodiode.

In reference to figure 4, the inverting output $V_{out1}$ and non-inverting output $V_{out2}$ may be connected to a two stage differential feedback amplifier gain stage 5. The two stage differential feedback amplifier gain stage 5 may be a Cherry-Hooper gain stage.

Figure 7a shows the 50 Gb/s simulated eye diagrams of a photoreceiver using a high speed photodiode model integrated with a transimpedance front-end architecture according to the prior art. Figure 7b shows the 50 Gb/s simulated eye diagrams of a front-end architecture according to the invention. In the case of the transimpedance front-end architecture according to the prior art, the eye closure due to the limited bandwidth is observable, leading to a totally closed eye when PAM-4 modulation format is used. The front-end architecture according to the invention on the contrary shows a perfectly open eye in both NRZ and PAM-4 operation at 50 Gbd, allowing the receiver according to the invention to work at 100 Gbit/s.

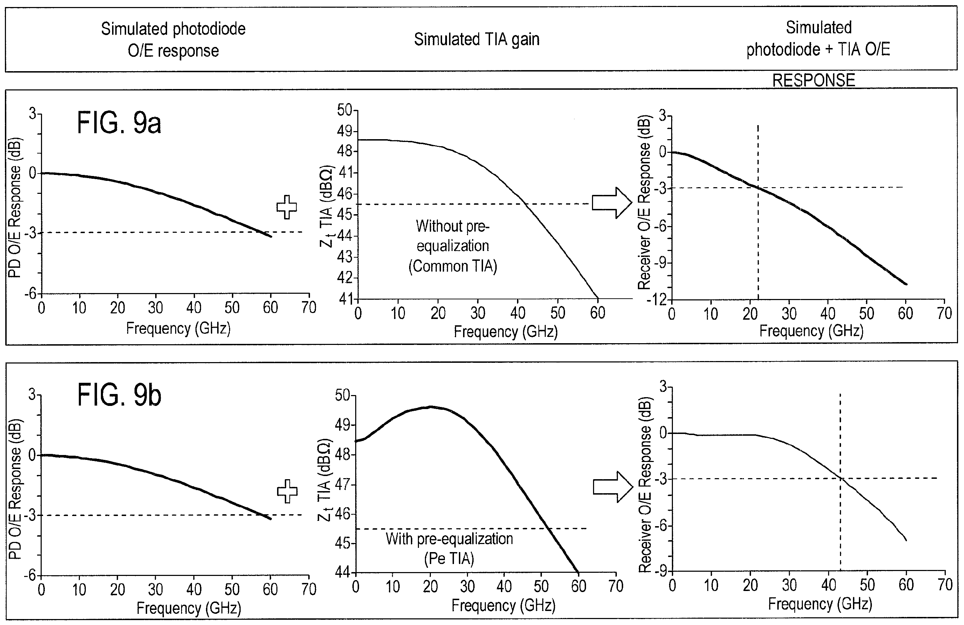

Figure 9a shows the simulated photodiode optical-to-electrical response, the simulated TIA gain, and the simulated photodiode and TIA optical-to-electrical response of a photoreceiver using a high speed photodiode model integrated with a transimpedance front-end architecture according to the prior art. Figure 9b shows the simulated photodiode optical-to-electrical response, the simulated TIA gain, and the simulated photodiode and TIA optical-to-electrical response of a photoreceiver according to the invention. The photoreceiver according to the invention exhibits frequency peaking where the photoreceiver according to the prior art does not.

The invention is not limited to the described embodiments. The appended claims are to be construed as embodying all modification and alternative constructions that may be occurred to one skilled in the art, which fairly fall within the basic teaching here, set forth.

The use of the verb "to comprise" or "to include" and its conjugations does not exclude the presence of elements or steps other than those stated in a claim. Furthermore, the use of the article "a" or "an" preceding an element or step does not exclude the presence of a plurality of such elements or steps. The invention may be implemented by means of hardware as well as software. The same item of hardware may represent several "means".

In the claims, any reference signs placed between parentheses shall not be construed as limiting the scope of the claims.

## Claims

1. Front-end architecture (10) for a photoreceiver (100), the front-end architecture (10) including a photodiode (1) and a fully differential amplifier (2), the fully differential amplifier (2) comprising a differential input amplifier (3) having a primary input (31), and at least one secondary input (32, 33,... 3N + 1), a primary output (51), a secondary output (52), a primary negative feedback path (41) creating a negative feedback from the primary output (51) to the primary input (31), and, for the at least one secondary input (32, 33,... 3N + 1), a secondary negative feedback path (42, 43,...4N+1) creating a negative feedback from the secondary output (52) to said secondary input (32, 33, ... 3N + 1), the primary negative feedback path (41) including a primary feedback element (411), the secondary negative feedback path (42, 43,...4N+1) including a secondary feedback element (421), **characterized in that** an anode of the photodiode (1) is connected to the primary input (31) of the differential input amplifier (3), and that the at least one secondary input (32, ... 3N + 1) is loaded by a respective impedance ($Z_{in2}$,... $Z_{inN+1}$), by connecting the at least one secondary input to a transmission line loaded by an open circuit (61).

2. Front-end architecture (10) for a photoreceiver (100) according to claim 1, wherein the primary input (31) is a non-inverting input with respect to the primary output (51), the at least one secondary input (32, 33, ... 3N + 1) is an inverting input with respect to the secondary output (52), wherein the primary output (51) is an inverting output (51) with respect to the primary input (31), and wherein the secondary output (52) is a non-inverting output (52) with respect to the at least one secondary input (32, 33, ... 3N + 1).

3. Front-end architecture (10) for a photoreceiver (100) according to claim 1, wherein the primary input (31) is an inverting input with respect to the primary output (51), the at least one secondary input (32, 33, ... 3N + 1) is a non-inverting input with respect to the secondary output (52), wherein the primary output (51) is a non-inverting output (51) with respect to the primary input (31), and wherein the secondary output (52) is an inverting output (52) with respect to the at least one secondary input (32, 33, ... 3N + 1).

4. Front-end architecture (10) for a photoreceiver (100) according to any of claims 1 to 3, wherein the primary feedback element (411) and the secondary feedback element (421) are resistors.

5. Front-end architecture (10) for a photoreceiver (100) according to any of claims 1 to 4, wherein the primary feedback element (411) and the secondary feedback element (421) have the same impedance.

6. Front-end architecture (10) for a photoreceiver (100) according to any of claims 1 to 5, wherein the front-end architecture (10) includes N secondary inputs (32, 33, ... 3N + 1) with $N \geq 2$, wherein for each one of the secondary inputs (32, 33, ... 3N + 1), a secondary negative feedback path (42, 43,...4N+1) creates a negative feedback from the secondary output (52) to said secondary input (32, 33, ... 3N + 1), so that output voltages $V_{out1}$ at the primary output (51) and $V_{out2}$ at the secondary output (52) are defined as :

$$V_{out1} = -V_{out2} = A \sum_0^N |\alpha_i| V_{in1}(t - \tau_i)$$

wherein input voltages at the secondary inputs (32, 33...3N+1) are attenuated and delayed images of a useful signal $V_{in1}$ from the photodiode, wherein $i$ denotes an integer index identifying the secondary inputs, wherein $|\alpha_i|$ denotes an attenuation of the input voltage at a corresponding secondary input and $\tau_i$ denotes a delay at a corresponding secondary input, wherein said attenuation decreases with the increase of said delay.

7. Front-end architecture (10) for a photoreceiver (100) according to any of claims 1 to 6, wherein the differential input amplifier (3) includes a differential stage (21), a buffer stage (22), and a level-shifting stage (23).

8. Front-end architecture (10) for a photoreceiver (100) according to claim 7, wherein the differential stage (21) includes a primary differential stage transistor (Q1) and, for each secondary input (32, 33,... 3N + 1), a secondary differential stage transistor (Q2), the buffer stage (22) including a primary buffer stage transistor (Q3) and, for each secondary input (32, 33, ... 3N + 1), a secondary buffer stage transistor (Q4), and the level-shifting stage (23) including a primary level-shifting stage transistor (Q5) and, for each secondary input (32, 33, ... 3N + 1), a secondary level-shifting stage transistor (Q6), each one of the transistors (Q1-Q6) including a base, a collector, and an emitter.

9. Front-end architecture (10) for a photoreceiver (100) according to claim 8, wherein the base of the primary differential stage transistor (Q1) is connected to the primary input (31), the collector of the primary differential stage transistor (Q1) is connected to the base of the primary buffer stage transistor (Q3), the emitter of the primary buffer stage transistor (Q3) is connected to the collector of the primary level-shifting stage transistor (Q5), the base of the primary differential stage transistor (Q1) is connected to the collector of the primary level-shifting stage transistor (Q5) through the primary feedback element (411), the emitter of the primary level-shifting stage transistor (Q5) is connected to the primary output (51), and, for each secondary input (32, 33, ... 3N + 1), the base of the associated secondary differential stage transistors (Q2) is connected to the secondary input (32, 33,... 3N + 1), the collector of the associated secondary differential stage transistors (Q2) is connected to the base of the associated secondary buffer stage transistor (Q4), the emitter of the associated secondary buffer stage transistor (Q4) is connected to the collector of the associated secondary level-shifting stage transistor (Q6), the base of the associated secondary differential stage transistor (Q2) is connected to the collector of the associated secondary level-shifting stage transistor (Q6) through the associated secondary feedback element (421), the emitter of the associated secondary level-shifting stage transistor (Q6) is connected to the secondary output (52).

10. Photoreceiver (100) including a front-end architecture (10) for a photoreceiver (100) according to any of claims 1 to 9.

11. Photoreceiver according to claim 10, wherein the primary output (51) and secondary output (52) are connected to a two stages differential feedback amplifier gain stage (5).

12. Photoreceiver according to claim 11, wherein the two stages differential feedback amplifier gain stage (5) is a Cherry-Hooper gain stage.

**Patentansprüche**

1. Frontendarchitektur (10) für einen Lichtempfänger (100), wobei die Frontendarchitektur (10) eine Fotodiode (1) und einen vollständigen Differenzverstärker (2) beinhaltet, wobei der vollständige Differenzverstärker (2) einen Differenzeingangsverstärker (3) umfasst, der einen primären Eingang (31) und mindestens einen sekundären Eingang (32, 33, ... 3N + 1), einen primären Ausgang (51), einen sekundären Ausgang (52) einen primären negativen Rückkopplungspfad (41), der eine negative Rückkopplung vom primären Ausgang (51) zum primären Eingang (31) erzeugt, und, für den mindestens einen sekundären Eingang (32, 33, ... 3N + 1), einen sekundären negativen Rückkopplungspfad (42, 43, ... 4N + 1), der eine negative Rückkopplung vom sekundären Ausgang (52) zum sekundären Eingang (32, 33, ... 3N + 1) erzeugt, aufweist, wobei der primäre negative Rückkopplungspfad (41) ein primäres Rückkopplungselement (411) beinhaltet, wobei der sekundäre negative Rückkopplungspfad (42, 43, ... 4N + 1) ein sekundäres Rückkopplungselement (421) beinhaltet, **dadurch gekennzeichnet ist, dass** eine Anode der Fotodiode (1) mit dem primären Eingang (31) des Differenzeingangsverstärkers (3) verbunden ist, und dass der mindestens eine sekundäre Eingang durch Verbinden des mindestens einen sekundären Eingangs (32, ... 3N + 1) mit einer Übertragungsleitung, die von einer offenen Schaltung (61) geladen wird, von einer jeweiligen Impedanz ($Z_{in2}$, ... $Z_{inN+1}$) geladen wird.

2. Frontendarchitektur (10) für einen Lichtempfänger (100) nach Anspruch 1, wobei der primäre Ausgang (31) mit Bezug auf den primären Ausgang (51) ein nichtinvertierender Eingang ist, der mindestens eine sekundäre Eingang (32, 33, ... 3N + 1) mit Bezug auf den sekundären Ausgang (52) ein invertierender Eingang ist, wobei der primäre Ausgang (51) mit Bezug auf den primären Eingang (31) ein invertierender Eingang (51) ist und wobei der sekundäre Ausgang (52) mit Bezug auf den mindestens einen sekundären Eingang (32, 33, ... 3N + 1) ein nichtinvertierender Ausgang (52) ist.

3. Frontendarchitektur (10) für einen Lichtempfänger (100) nach Anspruch 1, wobei der primäre Ausgang (31) mit Bezug auf den primären Ausgang (51) ein invertierender Eingang ist, der mindestens eine sekundäre Eingang (32, 33, ... 3N + 1) mit Bezug auf den sekundären Ausgang (52) ein nichtinvertierender Eingang ist, wobei der primäre Ausgang (51) mit Bezug auf den primären Eingang (31) ein nichtinvertierender Eingang (51) ist und wobei der sekundäre Ausgang (52) mit Bezug auf den mindestens einen sekundären Eingang (32, 33, ... 3N + 1) ein invertierender Ausgang (52) ist.

4. Frontendarchitektur (10) für einen Lichtempfänger (100) nach einem der Ansprüche 1 bis 3, wobei das primäre Rückkopplungselement (411) und das sekundäre Rückkopplungselement (421) Widerstände sind.

5. Frontendarchitektur (10) für einen Lichtempfänger (100) nach einem der Ansprüche 1 bis 4, wobei das primäre Rückkopplungselement (411) und das sekundäre Rückkopplungselement (421) dieselbe Impedanz haben.

6. Frontendarchitektur (10) für einen Lichtempfänger (100) nach einem der Ansprüche 1 bis 5, wobei die Frontendarchitektur (10) N sekundäre Eingänge (32, 33, ... 3N + 1) mit N ≥ 2 beinhaltet, wobei für jeden der sekundären Eingänge (32, 33, ... 3N + 1) ein sekundärer negativer Rückkopplungspfad (42, 43, ... 4N + 1) eine negative Rückkopplung vom sekundären Ausgang (52) zum sekundären Eingang (32, 33, ... 3N + 1) erzeugt, derart, dass Ausgangsspannungen $V_{out1}$ am primären Ausgang (51) und $V_{out2}$ am sekundären Ausgang (52) wie folgt definiert sind:

$$V_{out1} = -V_{out2} = A \sum_{0}^{N} |\alpha_i| V_{in1}(t - \tau_i)$$

wobei Eingangsspannungen an den sekundären Eingängen (32, 33 ... 3N + 1) gedämpfte und verzögerte Bilder eines nützlichen Signals $V_{in1}$ von der Fotodiode sind, wobei *i* einen ganzzahligen Index bezeichnet, der die sekundären Eingänge identifiziert, wobei $|\alpha_i|$ eine Dämpfung der Eingangsspannung an einem entsprechenden sekundären Eingang bezeichnet und $\tau_i$ eine Verzögerung an einem entsprechenden sekundären Eingang bezeichnet, wobei die Dämpfung mit der Zunahme der Verzögerung abnimmt.

7. Frontendarchitektur (10) für einen Lichtempfänger (100) nach einem der Ansprüche 1 bis 6, wobei der Differenzeingangsverstärker (3) eine Differenzstufe (21), eine Pufferstufe (22) und eine Pegelverschiebungsstufe (23) beinhaltet.

8. Frontendarchitektur (10) für einen Lichtempfänger (100) nach Anspruch 7, wobei die Differenzstufe (21) einen primären Differenzstufentransistor (Q1) und, für jeden sekundären Eingang (32, 33, ... 3N + 1), einen sekundären Differenzstufentransistor (Q2) beinhaltet, wobei die Pufferstufe (22) einen primären Pufferstufentransistor (Q3) und, für jeden sekundären Eingang (32, 33, ... 3N + 1), einen sekundären Pufferstufentransistor (Q4) beinhaltet und wobei die Pegelverschiebungsstufe (23) einen primären Pegelverschiebungsstufentransistor (Q5) und, für jeden sekundären Eingang (32, 33, ... 3N + 1), einen sekundären Pegelverschiebungsstufentransistor (Q6) beinhaltet, wobei jeder der Transistoren (Q1-Q6) eine Basis, einen Kollektor und einen Emitter beinhaltet.

9. Frontendarchitektur (10) für einen Lichtempfänger (100) nach Anspruch 8, wobei die Basis des primären Differenzstufentransistors (Q1) mit dem primären Eingang (31) verbunden ist, der Kollektor des primären Differenzstufentransistors (Q1) mit der Basis des primären Pufferstufentransistors (Q3) verbunden ist, der Emitter des primären Pufferstufentransistors (Q3) mit dem Kollektor des primären Pegelverschiebungsstufentransistors (Q5) verbunden ist, die Basis des primären Differenzstufentransistors (Q1) über das primäre Rückkopplungselement (411) mit dem Kollektor des primären Pegelverschiebungsstufentransistors (Q5) verbunden ist, der Emitter des primären Pegelverschiebungsstufentransistors (Q5) mit dem primären Ausgang (51) verbunden ist und, für jeden sekundären Eingang (32, 33, ... 3N + 1), die Basis der verknüpften sekundären Differenzstufentransistoren (Q2) mit dem sekundären Eingang (32, 33, ... 3N + 1) verbunden ist, der Kollektor der zugehörigen sekundären Differenzstufentransistoren (Q2) mit der Basis des zugehörigen sekundären Pufferstufentransistors (Q4) verbunden ist, der Emitter des zugehörigen sekundären Pufferstufentransistors (Q4) mit dem Kollektor des zugehörigen sekundären Pegelverschiebungsstufentransistors (Q6) verbunden ist, die Basis des zugehörigen sekundären Differenzstufentransistors (Q2) über das zugehörige sekundäre Rückkopplungselement (421) mit dem Kollektor des zugehörigen sekundären Pegelverschiebungsstufentransistors (Q6) verbunden ist, der Emitter des zugehörigen sekundären Pegelverschiebungsstufentransistors (Q6) mit dem sekundären Ausgang (52) verbunden ist.

10. Lichtempfänger (100), der eine Frontendarchitektur (10) für einen Lichtempfänger (100) nach einem der Ansprüche 1 bis 9 beinhaltet.

11. Lichtempfänger nach Anspruch 10, wobei der primäre Ausgang (51) und der sekundäre Ausgang (52) mit der Verstärkungsstufe (5) eines zweistufigen Rückkopplungsdifferenzverstärkers verbunden sind.

12. Lichtempfänger nach Anspruch 11, wobei die Verstärkungsstufe (5) des zweistufigen Rückkopplungsdifferenzverstärkers eine Cherry-Hooper-Verstärkungsstufe ist.

## Revendications

1. Architecture frontale (10) pour un photorécepteur (100), l'architecture frontale (10) incluant une photodiode (1) et un amplificateur entièrement différentiel (2), l'amplificateur entièrement différentiel (2) comprenant un amplificateur d'entrée différentiel (3) ayant une entrée primaire (31), et au moins une entrée secondaire (32, 33, ... 3N + 1), une sortie primaire (51), une sortie secondaire (52), un chemin primaire de rétroaction négative (41) créant une rétroaction négative de la sortie primaire (51) à l'entrée primaire (31), et, pour la au moins une entrée secondaire (32, 33, ... 3N + 1), un chemin secondaire de rétroaction négative (42, 43, ... 4N + 1) créant une rétroaction négative de la sortie secondaire (52) à ladite entrée secondaire (32, 33, ... 3N + 1), le chemin primaire de rétroaction négative (41) incluant un élément primaire de rétroaction (411), le chemin secondaire de rétroaction négative (42, 43, ... 4N + 1) incluant un élément secondaire de rétroaction (421),
**caractérisé en ce qu'**une anode de la photodiode (1) est connectée à l'entrée primaire (31) de l'amplificateur d'entrée différentiel (3), et **en ce que** la au moins une entrée secondaire (32, ... 3N + 1) est chargée par une impédance respective ($Z_{in2}$, ... $Z_{inN+1}$), par la connexion de la au moins une entrée secondaire à une ligne de transmission chargée par un circuit ouvert (61).

2. Architecture frontale (10) pour un photorécepteur (100) selon la revendication 1, dans laquelle l'entrée primaire (31) est une entrée non inverseuse par rapport à la sortie primaire (51), la au moins une entrée secondaire (32, 33, ... 3N + 1) est une entrée inverseuse par rapport à la sortie secondaire (52), dans laquelle la sortie primaire (51) est une sortie inverseuse (51) par rapport à l'entrée primaire (31), et dans laquelle la sortie secondaire (52) est une sortie non inverseuse (52) par rapport à la au moins une entrée secondaire (32, 33, ... 3N + 1).

3. Architecture frontale (10) pour un photorécepteur (100) selon la revendication 1, dans laquelle l'entrée primaire (31) est une entrée inverseuse par rapport à la sortie primaire (51), la au moins une entrée secondaire (32, 33, ... 3N + 1) est une entrée non inverseuse par rapport à la sortie secondaire (52), dans laquelle la sortie primaire (51) est une sortie non inverseuse (51) par rapport à l'entrée primaire (31), et dans laquelle la sortie secondaire (52) est une sortie inverseuse (52) par rapport à la au moins une entrée secondaire (32, 33, ... 3N + 1).

4. Architecture frontale (10) pour un photorécepteur (100) selon l'une quelconque des revendications 1 à 3, dans laquelle l'élément primaire de rétroaction (411) et l'élément secondaire de rétroaction (421) sont des résistances.

5. Architecture frontale (10) pour un photorécepteur (100) selon l'une quelconque des revendications 1 à 4, dans laquelle l'élément primaire de rétroaction (411) et l'élément secondaire de rétroaction (421) possèdent la même impédance.

6. Architecture frontale (10) pour un photorécepteur (100) selon l'une quelconque des revendications 1 à 5, dans laquelle l'architecture frontale (10) inclut N entrées secondaires (32, 33, ... 3N + 1) avec N ≥ 2, dans laquelle pour chacune des entrées secondaires (32, 33, ... 3N + 1), un chemin secondaire de rétroaction négative (42, 43, ... 4N + 1) crée une rétroaction négative de la sortie secondaire (52) à ladite entrée secondaire (32, 33, ... 3N + 1), de sorte que des tensions de sortie $V_{out1}$ au niveau de la sortie primaire (51) et $V_{out2}$ au niveau de la sortie secondaire (52) soient définies comme :

$$V_{out1} = -V_{out2} = A \sum_0^N |\alpha_i| V_{in1}(t - \tau_i)$$

dans laquelle des tensions d'entrée au niveau des entrées secondaires (32, 33, ... 3N + 1) sont des images atténuées et retardées d'un signal utile $V_{in1}$ provenant de la photodiode, dans laquelle $i$ représente un indice entier identifiant les entrées secondaires, dans laquelle $|\alpha_i|$ représente une atténuation de la tension d'entrée au niveau d'une entrée secondaire correspondante et $\tau_i$ représente un retard au niveau d'une entrée secondaire correspondante, dans laquelle ladite atténuation diminue avec l'augmentation dudit retard.

7. Architecture frontale (10) pour un photorécepteur (100) selon l'une quelconque des revendications 1 à 6, dans laquelle l'amplificateur d'entrée différentiel (3) inclut un étage différentiel (21), un étage tampon (22) et un étage de décalage de niveau (23).

8. Architecture frontale (10) pour un photorécepteur (100) selon la revendication 7, dans laquelle l'étage différentiel (21) inclut un transistor primaire d'étage différentiel (Q1) et, pour chaque entrée secondaire (32, 33, ... 3N + 1), un transistor secondaire d'étage différentiel (Q2), l'étage tampon (22) incluant un transistor primaire d'étage tampon (Q3) et, pour chaque entrée secondaire (32, 33, ... 3N + 1), un transistor secondaire d'étage tampon (Q4), et l'étage de décalage de niveau (23) incluant un transistor primaire d'étage de décalage de niveau (Q5) et, pour chaque entrée secondaire (32, 33, ... 3N + 1), un transistor secondaire d'étage de décalage de niveau (Q6), chacun des transistors (Q1 à Q6) incluant une base, un collecteur et un émetteur.

9. Architecture frontale (10) pour un photorécepteur (100) selon la revendication 8, dans laquelle la base du transistor primaire d'étage différentiel (Q1) est connectée à l'entrée primaire (31), le collecteur du transistor primaire d'étage différentiel (Q1) est connecté à la base du transistor primaire d'étage tampon (Q3), l'émetteur du transistor primaire d'étage tampon (Q3) est connecté au collecteur du transistor primaire d'étage de décalage de niveau (Q5), la base du transistor primaire d'étage différentiel (Q1) est connectée au collecteur du transistor primaire d'étage de décalage de niveau (Q5) par le biais de l'élément primaire de rétroaction (411), l'émetteur du transistor primaire d'étage de décalage de niveau (Q5) est connecté à la sortie primaire (51), et, pour chaque entrée secondaire (32, 33, ... 3N + 1), la base des transistors secondaires d'étage différentiel (Q2) associés est connectée à l'entrée secondaire (32, 33, ... 3N + 1), le collecteur des transistors secondaires d'étage différentiel (Q2) associés est connecté à la base du transistor secondaire d'étage tampon (Q4) associé, l'émetteur du transistor secondaire d'étage tampon (Q4) associé est connecté au collecteur du transistor secondaire d'étage de décalage de niveau (Q6) associé, la base du transistor secondaire d'étage différentiel (Q2) associé est connectée au collecteur du transistor secondaire d'étage de décalage de niveau (Q6) associé par le biais de l'élément secondaire de rétroaction (421) associé, l'émetteur du transistor secondaire d'étage de décalage de niveau (Q6) associé est connecté à l'entrée secondaire (52).

10. Photorécepteur (100) incluant une architecture frontale (10) pour un photorécepteur (100) selon l'une quelconque des revendications 1 à 9.

11. Photorécepteur selon la revendication 10, dans lequel la sortie primaire (51) et la sortie secondaire (52) sont connectées à un étage de gain d'amplificateur différentiel à rétroaction à deux étages (5).

12. Photorécepteur selon la revendication 11, dans lequel l'étage de gain d'amplificateur différentiel à rétroaction à deux étages (5) est un étage de gain de Cherry-Hooper.

a) Low impedance front-end
R $_L$ = 50 Ohms

**FIG. 1**

b) High impedance front-end
R $_L$ >> 50 Ohms

**FIG. 2**

c) Transimpedance front-end

**FIG. 3**

**FIG. 4**

FIG. 5a

FIG. 5b

$$\alpha_i = |\alpha_i| \exp(-j\omega\tau_i)$$

FIG. 6

FIG. 8b

FIG. 7a

Simulated 50 Gbit/s NRZ
Photodiode+TIA (classic)
output eye diagram

Simulated 50 GBd PAM4
Photodiode+TIA (classic)
output eye diagram

a)

FIG. 7b

Simulated 50 Gbit/s NRZ
Photodiode+Pre-Equalizing TIA
output eye diagram

Simulated 50 GBd PAM4
Photodiode+Pre-Equalizing TIA
output eye diagram

b)

Simulated photodiode O/E response · Simulated TIA gain · Simulated photodiode + TIA O/E RESPONSE

FIG. 9a

FIG. 9b

Without pre-equalization (Common TIA)

With pre-equalization (Pe TIA)

FIG. 8a

FIG. 8c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6768384 B